# EUROPÄISCHE PATENTANMELDUNG

(11) **EP 1 365 640 A2**
(43) Veröffentlichungstag der Anmeldung: **26.11.2003**
(21) Anmeldenummer: 03011542.2
(22) Anmeldetag: 21.05.2003
(51) Int. Cl.: H05K 9/00

(54) **EMV-Abschirmung für elektronische Bauelemente und EMV-Gehäuse**

(30) Priorität: 24.05.2002 DE 10223170
(71) Anmelder: SIEMENS AKTIENGESELLSCHAFT, 80333 München (DE)
(72) Erfinder: Albayrak, Gökhan, 78048 Villingen-Schwenningen (DE); Miethig, Werner, 78086 Brigachtal (DE); Ulmer, Patrick, 78048 Villingen-Schwenningen (DE)

(57) **Zusammenfassung**

Es wird eine EMV-Abschirmung für elektronische Bauelemente auf einer Leiterplatte bereitgestellt, die ein die elektronischen Bauelemente wenigstens an den nicht der Leiterplatte (10) zugewandten Seiten umschließendes, elektromagnetische Strahlung abschirmendes Gehäuse (12) aufweist, wobei das Gehäuse (12) eine Vielzahl von elektrisch leitenden Federkontakten (14) aufweist, die die Leiterplatte (10) elektrisch leitend kontaktieren, und das Gehäuse (12) mittels wenigstens einer Druckkontaktierungseinrichtung (16) an die Leiterplatte gepresst ist.

## Beschreibung

Die vorliegende Erfindung betrifft eine EMV-Abschirmung für elektronische Bauelemente auf einer Leiterplatte gemäß dem Oberbegriff von Patentanspruch 1 sowie ein EMV-Gehäuse gemäß dem Oberbegriff von Patentanspruch 8.

Bei elektronischen Geräten wird aufgrund einer immer größer werdenden Empfindlichkeit sowie zunehmender Leistungsfähigkeit und immer höherer Taktraten moderner elektronischer Bauelemente die Abschirmung gegen elektromagnetische Strahlung zunehmend relevant. Die in verschiedenen Normen festgelegte elektromagnetische Verträglichkeit (EMV) für elektronische Geräte fordert deshalb Maßnahmen sowohl zum Schutz der elektronischen Bauelemente vor elektromagnetischer Fremdeinstrahlung als auch eine Reduzierung der von den elektronischen Bauelementen erzeugten elektromagnetischen Eigenabstrahlung. Anwendungsgebiete, in denen EMV-Abschirmungen von elektronischen Bauelementen eingesetzt werden, sind beispielsweise elektronische Steuergeräte in der Kraftfahrzeugtechnik und im Hochfrequenzbereich betriebene Kommunikationsendgeräte wie Mobiltelefone.

Zur Ausbildung einer EMV-Abschirmung von elektronischen Bauelementen auf einer Leiterplatte besteht beispielsweise die Möglichkeit, die gesamte Leiterplatte mit den elektronischen Bauelementen innerhalb eines elektromagnetische Strahlung abschirmenden Gehäuses anzuordnen. Ein derartiges Abschirmgehäuse ist zum Beispiel aus der DE-A1-199 56 184 bekannt. Nachteilig an dieser Lösung sind allerdings die Bereitstellung von Anschlüssen, die von der Leiterplatte aus dem Abschirmgehäuse EMV-gerecht herausgeführt werden müssen, die fehlende Abschirmung einzelner elektronischer Bauelemente gegeneinander und das aufgrund der Größe des Gehäuses relativ große Gewicht des Abschirmgehäuses.

Zur Vermeidung dieser Nachteile werden heute hauptsächlich lokale EMV-Abschirmungen eingesetzt, die unmittelbar um die jeweiligen elektronischen Bauelemente herum vorgesehen sind, wie dies beispielsweise in der DE-A1-41 37 112 vorgeschlagen ist.

Üblicherweise werden solche lokalen EMV-Abschirmungen durch ein Schirmgehäuse aus vier Seitenwänden mit einem Deckel realisiert, wobei die Seitenwände mit der Leiterplatte verlötet werden. Hierzu kann entweder die EMV-Abschirmung, wie dies in der DE-C1-198 40 234 beschrieben ist, und/oder die Leiterplatte mit einem Lotdepot versehen sein. Alternativ können die Seitenwände der EMV-Abschirmung auch Lötzapfen aufweisen, die durch entsprechende Löcher in der Leiterplatte geführt und rückseitig verlötet werden. Nachteilig an diesen Lösungen ist die erforderliche hohe Anzahl an Lötpunkten und die dafür notwendigen teuren Löteinrichtungen sowie im letztgenannten Fall der Durchkontaktierungen zusätzlich eine Einschränkung des Leiterplatten-Layouts.

Der vorliegenden Erfindung liegt die Aufgabe zugrunde, eine EMV-Abschirmung und ein EMV-Gehäuse für elektronische Bauelemente auf einer Leiterplatte vorzusehen, die bzw. das unter Beibehaltung der EMV-Eigenschaften einfach und kostengünstig montierbar ist.

Diese Aufgabe wird durch eine EMV-Abschirmung und ein EMV-Gehäuse mit den Merkmalen des Patentanspruches 1 bzw. 8 gelöst. Vorteilhafte Ausgestaltungen und Weiterbildungen der EMV-Abschirmung und des EMV-Gehäuses sind in den abhängigen Ansprüchen 1 bis 7 bzw. 9 bis 12 genannt.

Die EMV-Abschirmung für elektronische Bauelemente auf einer Leiterplatte gemäß der Erfindung weist ein die elektronischen Bauelemente wenigstens an den nicht der Leiterplatte zugewandten Seiten umschließendes, elektromagnetische Strahlung abschirmendes Gehäuse auf, wobei das Gehäuse eine Vielzahl von elektrisch leitenden Federkontakten aufweist, die die Leiterplatte elektrisch leitend kontaktieren, und das Gehäuse mittels wenigstens einer Druckkontaktierungseinrichtung, insbesondere einer Verschraubungseinrichtung, an die Leiterplatte gepresst ist.

Die Federkontakte des Gehäuses dienen der elektrischen Kontaktierung mit der Leiterplatte und die Druckkontaktierungseinrichtung sorgt für die für eine zuverlässige elektrische Kontaktierung notwendige Anpresskraft des Gehäuses an die Leiterplatte. Bei der erfindungsgemäßen Lösung entfällt bei der Montage der aufwändige Lötvorgang und die dafür notwendigen teuren Löteinrichtungen, die bei herkömmlichen Systemen erforderlich sind. Stattdessen sind nur wenige Druckkontaktierungsverbindungen durchzuführen, die vorteilhafterweise auch zur Befestigung weiterer Bauteile mitgenutzt werden können.

In einem bevorzugten Ausführungsbeispiel der Erfindung weist das Gehäuse wenigstens eine Lasche mit einer Ausnehmung, insbesondere mit einer Bohrung zur Durchführung einer Schraube auf.

Zur Verbesserung der elektrischen Kontaktierung zwischen Gehäuse und Leiterplatte kann die Leiterplatte an ihrer dem Gehäuse zugewandten Oberfläche zusätzlich ein Lotdepot aufweisen.

Vorzugsweise weist die Leiterplatte wenigstens eine Ausnehmung zur Aufnahme wenigstens eines zum Eingriff in diese Ausnehmung vorgesehenen Vorsprungs an dem Gehäuse auf. Diese Mittel dienen zur einfacheren und genaueren Positionierung des Gehäuses auf der Leiterplatte.

Zur Ausbildung einer kompletten EMV-Abschirmung der elektronischen Bauelemente von allen Seiten ist vorzugsweise im Layout der Leiterplatte eine elektromagnetische Strahlung abschirmende Fläche vorgesehen, die auf der dem Gehäuse abgewandten Seite der elektronischen Bauelemente angeordnet ist.

Das Gehäuse kann wie bei herkömmlichen Systemen zum Beispiel ein Metallgehäuse oder ein metallisiertes Kunststoffgehäuse sein.

Das EMV-Gehäuse zur elektromagnetischen Abschirmung von elektronischen Bauelementen auf einer Leiterplatte gemäß der Erfindung weist mehrere Seitenwände und einen Deckel auf. An den Seitenwänden des Gehäuses sind eine Vielzahl von elektrisch leitenden Federkontakten und wenigstens eine Vorrichtung zur Aufnahme einer Druckkontaktierungseinrichtung, insbesondere einer Verschraubung vorgesehen.

Dieses EMV-Gehäuse kann insbesondere zur Ausbildung der oben beschriebenen EMV-Abschirmung gemäß der vorliegenden Erfindung eingesetzt werden.

In einer bevorzugten Ausführungsform ist die wenigstens eine Vorrichtung zur Aufnahme einer Druckkontaktierungseinrichtung durch eine Lasche mit einer Ausnehmung, insbesondere einer Bohrung zur Durchführung einer Schraube gebildet. Das Gehäuse weist wenigstens einen Vorsprung zum Eingreifen in eine zugeordnete Ausnehmung in einer Leiterplatte auf. Dies dient zur einfacheren und genaueren Positionierung des Gehäuses auf der Leiterplatte.

Das Gehäuse ist vorzugsweise ein Metallgehäuse oder ein metallisiertes Kunststoffgehäuse.

Die erfindungsgemäße Abschirmung und das erfindungsgemäße Gehäuse werden nachfolgend anhand eines Ausführungsbeispiels unter Bezugnahme auf die beiliegenden Zeichnungen näher erläutert. Darin zeigen:
- Figur 1: eine schematische Perspektivdarstellung eines auf einer Leiterplatte montierten EMV-Gehäuses zur Ausbildung einer EMV-Abschirmung gemäß der vorliegenden Erfindung; und
- Figur 2: eine schematische Perspektivdarstellung des EMV-Gehäuses von Figur 1 von unten mit weggelassener Leiterplatte.

Die EMV-Abschirmung des Ausführungsbeispiels dient zur Abschirmung von elektronischen Bauelementen auf einer Leiterplatte 10 gegen elektromagnetische Strahlung. Unter Abschirmung wird dabei sowohl der Schutz der elektronischen Bauelemente vor elektromagnetischer Fremdeinstrahlung als auch die Reduzierung der durch die elektronischen Bauelemente erzeugten elektromagnetischen Eigenabstrahlung nach außen verstanden.

Die EMV-Abschirmung besteht im wesentlichen aus einem EMV-Gehäuse 12 mit mehreren Seitenwänden 12a und einem Deckel 12b. Bei dem in den Figuren dargestellten Ausführungsbeispiel ist der Deckel 12b rechteckförmig ausgebildet und es sind folglich vier Seitenwände 12a vorhanden.

Die vorliegende Erfindung ist aber selbstverständlich nicht nur auf diese spezielle Gehäuseform beschränkt. Je nach der Anzahl, Größe und Anordnung der abzuschirmenden elektronischen Bauelemente auf der Leiterplatte 10 kann das Gehäuse 12 auch nur drei oder mehr als vier Seitenwände 12a und unterschiedlichste Grundformen des Deckels 12b aufweisen.

Das EMV-Gehäuse 12 besteht vorzugsweise aus Metall oder einem metallisierten Kunststoff.

Da das in den Figuren dargestellte Gehäuse 12 die elektronischen Bauelemente auf der Leiterplatte 10 nicht von allen Seiten umschließt, ist es von Vorteil, wenn zusätzlich im Layout der Leiterplatte 10 eine Abschirmfläche vorgesehen ist, die zusammen mit dem Gehäuse 12 die elektronischen Bauelemente vollständig umgibt.

Die Seitenwände 12a weisen an ihren der Leiterplatte 10 zugewandten Seiten jeweils mehrere Federkontakte 14 auf, die im wesentlichen senkrecht zu den Seitenwänden 12a nach außen ragen. Diese Federkontakte 14 kontaktieren bei montiertem EMV-Gehäuse 12 die Leiterplatte 10. Zur Verbesserung dieser elektrischen Kontaktierung kann zudem auf der Oberfläche der Leiterplatte 10 ein Lotdepot (nicht dargestellt) vorgesehen sein.

Die Anzahl der Federkontakte 14 und damit der Abstand zwischen den einzelnen Federkontakten 14 kann in Abhängigkeit von dem Frequenzbereich, der durch das EMV-Gehäuse 12 abgeschirmt werden soll, gewählt werden. In einer bevorzugten Ausführungsform haben die Federkontakte 14 eine Breite von etwa 1 mm und besitzen einen gegenseitigen Abstand von etwa 2 bis 3 mm, d.h. ein Rastermaß von etwa 3 bis 4 mm. Die Höhe des Gehäuses 12 hängt im wesentlichen von den abzuschirmenden elektronischen Bauelementen ab und kann einige mm bis cm betragen.

Um eine gute elektrische Kontaktierung der Federkontakte 14 mit der Leiterplatte 10 sicherzustellen, muss das Gehäuse 10 gegen die Leiterplatte 10 gepresst werden. Der Anpressdruck muss dabei so groß sein, dass ein möglichst geringer Ubergangswiderstand zwischen den Federkontakten und der Leiterplatte erzielt wird. Dies geschieht mittels wenigstens einer, im dargestellten Ausführungsbeispiel vier in die Leiterplatte 10 eingeschraubte Schrauben 16. Die Schrauben 16 sind durch Bohrungen 20 in nach außen ragenden Laschen 18 an den Seitenwänden 12a des Gehäuses 12 geführt und greifen in entsprechende Schraubgewindebohrungen (nicht dargestellt) in der Leiterplatte 10 ein.

Allein durch festes Anziehen der Verschraubung 16, d.h. insbesondere ohne aufwändige Lötprozesse, wird das Gehäuse 12 und werden damit die Federkontakte 14 gegen die Leiterplatte 10 bzw. das Lotdepot auf der Leiterplatte 10 gepresst. Um einen gleichmäßigen Anpressdruck zu gewährleisten, ist es von Vorteil, wenigstens an jeder Ecke des Gehäuses 12 eine Verschraubung 16 vorzusehen.

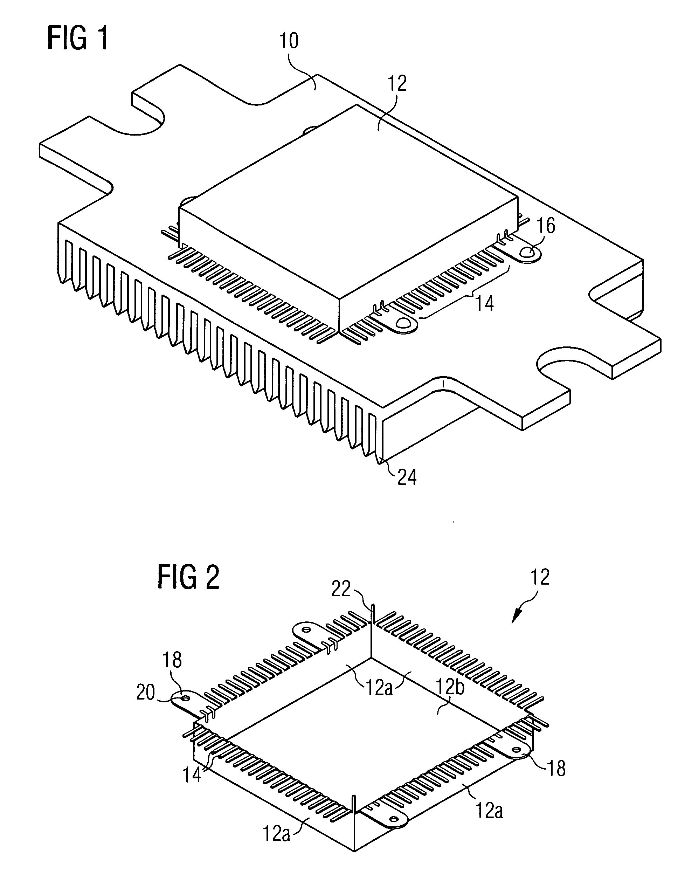

In vorteilhafter Weise können die Verschraubungen 16 zusätzlich zur Befestigung weiterer Bauteile mitgenutzt werden. In dem Ausführungsbeispiel von Figur 1 ist mittels der Verschraubung 16 als Beispiel ein Kühlkörper 24 an der Rückseite, d.h. der dem Gehäuse 12 abgewandten Seite der Leiterplatte 10 befestigt.

Alternativ oder zusätzlich zu den im Ausführungsbeispiel vorgesehenen Verschraubungen können andere Druckkontaktierungsmittel vorgesehen sein, wie beispielsweise Klammern oder Niete.

Um die Montage des EMV-Gehäuses 12 zu vereinfachen und eine exakte Positionierung des Gehäuses 12 auf der Leiterplatte 10 zu ermöglichen, sind an den der Leiterplatte 10 zugewandten Unterkanten der Seitenwände 12a mehrere Vorsprünge 22 vorgesehen, die in entsprechende Ausnehmungen in der Leiterplatte 10 eingreifen können. In dem Ausführungsbeispiel von Figur 2 sind insgesamt zwei Vorsprünge 22 an gegenüber liegenden Ecken des Gehäuses 12 vorgesehen.

Während bei dem oben beschriebenen und in den Figuren dargestellten Ausführungsbeispiel der Deckel 12b des Gehäuses 12 einstückig mit den Seitenwänden 12a des Gehäuses 12 ausgebildet ist, kann das Gehäuse selbstverständlich auch aus einem Seitenrahmen 12a und einem separat gefertigten Deckel 12b, der fest mit dem Seitenrahmen 12a verbindbar ist, aufgebaut sein.

Mittels der EMV-Abschirmung gemäß der vorliegenden Erfindung entfällt insbesondere ein aufwändiger und kostenintensiver Lötvorgang bei der Montage des EMV-Gehäuses auf der Leiterplatte. Außerdem wird das Layout der Leiterplatte nicht eingeschränkt, da das Gehäuse nicht mittels Lötzapfen durch die Leiterplatte durchkontaktiert wird.

## Patentansprüche

1. EMV-Abschirmung für elektronische Bauelemente auf einer Leiterplatte, mit einem die elektronischen Bauelemente wenigstens an den nicht der Leiterplatte (10) zugewandten Seiten umschließenden, elektromagnetische Strahlung abschirmenden Gehäuse (12),
**dadurch gekennzeichnet, dass**
das Gehäuse (12) eine Vielzahl von elektrisch leitenden Federkontakten (14) aufweist, die die Leiterplatte (10) elektrisch leitend kontaktieren, und das Gehäuse (12) mittels wenigstens eines Druckkontaktierungsmittels (16) an die Leiterplatte gepresst ist.

2. EMV-Abschirmung nach Anspruch 1,
**dadurch gekennzeichnet, dass**
das Druckkontaktierungsmittel (16) eine Verschraubung des Gehäuses (12) an der Leiterplatte (10) ist.

3. EMV-Abschirmung nach Anspruch 2,
**dadurch gekennzeichnet, dass**
das Gehäuse (12) wenigstens eine Lasche (18) mit einer Ausnehmung (20), insbesondere einer Bohrung zur Durchführung einer Schraube aufweist.

4. EMV-Abschirmung nach einem der Ansprüche 1 bis 3,
**dadurch gekennzeichnet, dass**
die Leiterplatte (10) an ihrer dem Gehäuse (12) zugewandten Oberfläche ein Lotdepot zur elektrischen Kontaktierung der Federkontakte (14) des Gehäuses (12) aufweist.

5. EMV-Abschirmung nach einem der Ansprüche 1 bis 4,
**dadurch gekennzeichnet, dass**
die Leiterplatte (10) wenigstens eine Ausnehmung zur Aufnahme wenigstens eines zum Eingriff in diese Ausnehmung vorgesehenen Vorsprungs (22) an dem Gehäuse (12) aufweist.

6. EMV-Abschirmung nach einem der Ansprüche 1 bis 5,
**dadurch gekennzeichnet, dass**
im Layout der Leiterplatte (10) eine elektromagnetische Strahlung abschirmende Fläche vorgesehen ist, die auf der dem Gehäuse abgewandten Seite der elektronischen Bauelemente angeordnet ist.

7. EMV-Abschirmung nach einem der Ansprüche 1 bis 6,
**dadurch gekennzeichnet, dass**
das Gehäuse (12) ein Metallgehäuse oder ein metallisiertes Kunststoffgehäuse ist.

8. EMV-Gehäuse zur elektromagnetischen Abschirmung von elektronischen Bauelementen auf einer Leiterplatte (10), mit mehreren Seitenwänden (12a) und einem Deckel (12b),
**dadurch gekennzeichnet, dass**
an den Seitenwänden (12a) des Gehäuses (12) eine Vielzahl von elektrisch leitenden Federkontakten (14) und wenigstens eine Vorrichtung (18, 20) zur Aufnahme eines Druckkontaktierungsmittels (16) vorgesehen sind.

9. EMV-Gehäuse nach Anspruch 8,
**dadurch gekennzeichnet, dass**
das Druckkontaktierungsmittel (16) eine Verschraubung ist.

10. EMV-Gehäuse nach Anspruch 9,
**dadurch gekennzeichnet, dass**
die wenigstens eine Vorrichtung zur Aufnahme des Druckkontaktierungsmittels (16) eine Lasche (18) mit einer Ausnehmung (20) zur Durchführung der Verschraubung (16) ist.

11. EMV-Gehäuse nach einem der Ansprüche 8 bis 10,
**dadurch gekennzeichnet, dass**
das Gehäuse (12) wenigstens einen Vorsprung (22) zum Eingreifen in eine zugehörige Ausnehmung in der Leiterplatte (10) aufweist.

12. EMV-Gehäuse nach einem der Ansprüche 8 bis 11,
**dadurch gekennzeichnet, dass**
das Gehäuse (12) ein Metallgehäuse oder ein metallisiertes Kunststoffgehäuse ist.
